# EUROPEAN PATENT SPECIFICATION

(11) **EP 3 283 848 B1**
(45) Date of publication and mention of the grant of the patent: **05.06.2019**
(21) Application number: 16720731.5
(22) Date of filing: 14.04.2016
(51) Int. Cl.: G01D 4/00, H04B 3/54

(54) **AN ELECTRICITY METER AND AN ADAPTOR MODULE THEREFOR**
STROMZÄHLER UND ANPASSUNGSMODUL DAFÜR
COMPTEUR ELECTRIQUE ET MODULE ADAPTATEUR CORRESPONDANT

(30) Priority: 17.04.2015 CH 5382015
(43) Date of publication of application: 21.02.2018
(73) Proprietor: Landis+Gyr AG, 6301 Zug (CH)
(72) Inventor: YLÖNEN, Juhani Ilmari, 44350 Istunmäki (FI); POIKONEN, Erkki Olavi, 40600 Jyväskylä (FI)
(74) Representative: IPrime Rentsch Kaelin AG
(86) International application number: PCT/EP2016/058260
(87) International publication number: WO 2016/166238

(56) References cited:
- EP-A1- 0 505 223
- US-A1- 2005 007 241
- US-A1- 2010 111 199
- US-A1- 2013 194 975

## Description

This disclosure relates to electricity meters for recording the electric energy consumption and an adaptor module therefor. More specifically, the disclosure relates to an electricity meter, which records the electric energy consumption and is capable of communicating data over power cabling. In particular, the disclosure is directed to a versatile adaptor module for the electricity meter.

### BACKGROUND

Smart metering technology takes more and more important role in the field of the metering, because both utilities and the end users consuming the electric energy benefit from this technology. Smart meters allow the utilities automatically and remotely accessing meter information, for example not only the electric energy consumed by the end users but also the distribution of the electric energy consumption depending on time of the day or seasons. The operating conditions of the meters installed at the end user can also be monitored remotely by the utilities. The end user may in turn obtain information from the utility more frequently.

For providing these functionalities, electricity meters rely on a reliable and secure two-way communication. Different communication technologies have been evaluated to be applied in an electricity meter. Communication over power cabling is one of the promising technologies. By communicating the data over the power cabling, no additional wiring or fiber for communication is needed. The utilities benefit from the existing infrastructure, the power cabling network. Therefore, the installation cost, maintenance cost for the communication network can be reduced.

The communication over power cabling provides a two-way communication. For transmitting the data, the data signal is modulated on a carrier signal and coupled to the power cabling, while for receiving the data the modulated data signal is first decoupled from the power cabling and then demodulated. In recent years, this communication technology finds a plurality of applications in different areas. Today, the communication over power cabling is a well-established technology. In particular, the recently developed G3-PLC standard supports highly reliable and secure communication over power cabling. The G3-PLC may operate different frequency bands allocated for different countries. For example, CENELEC A band having a frequency range between 35 kHz to 91 kHz, CENELEC B band having a frequency range between 98 kHz to 135 kHz, ARIB band having a frequency range between 155 kHz to 403 kHz, and FCC band having a frequency range between 155 kHz to 487 kHz. CENELEC A band and CENELEC B band are applicable in Europe, while ARIB band and FCC band are applicable in Japan, USA and other countries, respectively.

WO 2012/040476 discloses coupling circuits for power line communication devices. A power line communication device may comprise a processor and a coupling circuit coupled to the processor. The coupling circuit may in turn comprise a transmitter path and a receiver path. In some implementations, the transmitter path may include a first amplifier, a first capacitor coupled to the first amplifier, a first transformer coupled to the first capacitor, and a plurality of line interface coupling circuits coupled to the first transformer, wherein each of the line interface coupling circuits is configured to be connected to a different phase of an electrical power circuit.

WO 2009/000869 relates to a distributor power line communication system. The system comprises a communication server sending and receiving messages over a telecommunication network, a power distribution substation to which a power distribution network towards end users is connected, at least one gateway transferring messages from the telecommunication network onto the power distribution network in a predetermined frequency band, a plurality of smart metering devices at end user mains networks for measuring power consumption and comprising a power line communication modem sending and receiving messages within the predetermined frequency band over the power distribution network, power line communication filters on power lines connecting the power distribution network and the end user mains networks and on power lines connecting the power distribution network to the power distribution substation, each filter blocking frequencies within the predetermined frequency band.

US 2013/0194975 A1 describes methods and systems for switch table updates in power line communication (PLC) environments.

US 2010/0111199 A1 relates to a method and device for PLC, including a multi-band media access control layer configured to select frequency bands for communication.

EP 0 505 223 A1 relates to a system for PLC, including means for transmitting and receiving information in a plurality of predetermined frequency bands, which may be chosen according to signal quality and may change periodically.

### SUMMARY

It is an objective of this invention to provide an electricity meter and an adaptor module for the electricity meter which overcome at least some of the drawbacks known from the prior art.

It is a further objective of the invention to provide an electricity meter and an adaptor module for the electricity meter, which are versatile configurable in an efficient manner and at low cost.

According to the present invention, these objectives are achieved through the features of the independent claims. In addition, further advantageous embodiments follow from the dependent claims and the description.

According to the present invention, the above-mentioned objectives are particularly achieved in that an electricity meter comprises a metering unit, a communication unit and a processing unit. The metering unit is applied for determining the electric energy consumption. The communication unit is applied for communicating data signals within a communication band over power cabling. The processing unit is applied for controlling the metering unit and the communication unit. The communication unit is configured to adapt the communication band to the communication environment and comprises a signal processing unit, a switch being connected to the signal processing unit, and a control module for controlling the switch; wherein the signal processing unit has at least two operation modi depending on the state of the switch controlled by the control module; in a first operation mode, the signal processing unit selects electrical signals from a first frequency band and couples the selected electrical signals to a power cabling; in a second operation mode, the signal processing unit selects electrical signals from a second frequency band and couples the selected electrical signals to the power cabling; wherein the control module is configured to generate a control signal for controlling the switch based on a configuration signal, and wherein the configuration signal is generated dynamically.

The electricity meter may be applied in different communication environments, for example, allocated communication frequencies for communication over power cabling may be different in different countries, different utilities may require different frequencies for the communication over power cabling, in different surroundings the communication quality of different frequency bands may also vary. Since the communication unit is configured to adapt the communication band to the communication environment, the electricity meter may be installed in different location without a modification of the hardware of the electricity meter.

In some embodiments, a plurality of frequency bands are allocated as communication bands for communication over power cabling. The electricity meter is configured to switch from one of the allocated frequency bands to another allocated frequency band depending on the communication environment. The allocated frequency bands are CENELEC A, CENELEC B, FCC, ARIB and a combination of any of the previous. In different countries, different frequency bands are allocated for a communication over power cabling. When smart electricity meters are installed in different countries, the communication unit must be able to communicating the data signals within the frequency band allocated to different countries. Furthermore, the preferred frequency bands for a communication over power cabling are different from utility to utility. One prefers a communication in for example CENELEC A band, another one prefers a communication in FCC band or other frequency band. Moreover, a smart electricity meter may be installed in a meter reading system including a plurality of electricity meters and other electric devices, for example a concentrator. The concentrator may be configured to communicate over power cabling within a defined allocated frequency band. If the communication unit is configured to be able to switch from one of the allocated frequency band to another allocated frequency band depending on the communication environment, the electricity meter may be applied for different countries and for different utilities or meter reading systems without modifying its hardware. In addition, depending on the places, where the electricity meter is installed, the quality of communication within different allocated frequency bands is different depending on the other signals present in the proximity. If the quality of communication over power cabling within an allocated frequency band is bad, the communication unit is configured to switch from this allocated frequency band to another allocated frequency band. In this way, the quality of communication over power cabling can be optimized and a good quality of communication over power cabling is ensured.

The communication unit is preferred configured to switch from one frequency band to another frequency band depending on the communication environment. In one variant, this switching may occur automatically and adapts the frequency band for communication of the communication unit to the requirement regarding the communication frequency band for e.g. different locations, different utilities and different meter reading systems.

Alternatively or in combination of a foresaid determining requirement, the adaption is depending on the optimized technical communication quality with the power ca-bling (e.g. in certain surroundings communication within CENELEC band might provide more stable communication than within FCC band or other frequency band, or vice versa). Namely, the intelligent switching depending on the communication quality allows a dynamic switching solution with a complex communication. This intelligent switching can be done manually or by remotely signal or in some applications also automatically using self-learning or auto-detecting logic module.

In a preferred embodiment, the first frequency band and the second frequency band are one of the allocated frequency bands for a communication over power cabling. This has the advantage, that a versatile design of the electricity meter can be achieved.

According to the present invention, the above-mentioned objectives are particularly achieved in that an adaptor module for an electricity meter comprises a signal processing unit, a switch being connected to the signal processing unit and a control module for controlling the switch. The signal processing unit has at least two operation modi depending on the state of the switch controlled by the control module. In a first operation mode, the signal processing unit selects electrical signals from a first frequency band and couples the selected signals to the power cabling. In a second operation mode, the signal processing unit selects electrical signals from a second frequency band and couples the selected signals to the power cabling.

In some embodiments, in the first operation mode, the signal processing unit forms a band-pass filter to pass the electrical signals within the first frequency band. In the second mode, the signal processing unit forms a high-pass filter to pass the electrical signals within a second frequency band.

In some embodiments, the first frequency band and the second frequency band are one of the allocated frequency bands for a communication over power cabling, for example, CENELEC A, CENELEC B, FCC and ARIB.

In a preferred embodiment, the first frequency band is CENELEC A band and the second frequency band is FCC band, or vice versa.

In a variant, the configuration signal is initiated by an initiation signal, which is transmitted over a power cabling or a radio communication channel. The initiation signal is generated for example by a meter reading system including an electricity meter wherein the adaptor module is installed. The initiation signal is transmitted over a power cabling or a radio communication channel to the electricity meter, wherein the adaptor module is installed. The operation modi of the processing unit may be remotely controlled. Therefore, the adaptor module may be remotely adapted to communicating over power cabling within a defined frequency band in an efficient manner.

A logic module may be functionally connected to the control module or a processing unit of an electricity meter wherein the adaptor module is installed. The logic module may be self-learning and/or auto-detecting and may generate a configuration signal. Hence, an intelligent switching from one communication
frequency band to another frequency band can be achieved. This provides an optimal communication regarding the communication quality and versatile applications, for example independency of communication frequency band requirements on different countries, utilities and the devices connected in the same meter reading system.

In some embodiments, the switch is a relay, preferably an optoisolated relay.

In one variant, the signal processing unit comprises a first resistor, a first capacitor, a second capacitor and a first inductor, wherein the first capacitor, the second capacitor, and the first inductor are connected in series with the first inductor arranged between the first capacitor and the second capacitor, wherein the first resistor is connected in parallel to the first inductor.

In a preferred embodiment, the signal processing unit is configured to switch from the first operation mode to the second operation mode by shunting the first inductor. In one variant, the switch connected to the processing unit is controlled to the closed state and the first inductor is shunt. In this manner, the adaptor module or an electricity meter including the adaptor module may switch the communication frequency for power cabling communication from a first frequency band to a second frequency band.

### BRIEF DESCRIPTION OF THE DRAWINGS

In order to describe the manner in which advantages and features of the disclosure can be obtained, in the following a more particular description of the principles briefly described above will be rendered by reference to specific embodiments thereof which are illustrated in the appended drawings. These drawings depict only exemplary embodiments of the disclosure and are not therefore to be considered to be limiting of its scope.
- Fig. 1: illustrates a schematic diagram of an electricity meter;
- Fig. 2: illustrates a schematic diagram of an adaptor module for an electricity meter;
- Fig. 3: illustrates one exemplary implementation of remotely controlling a switch included in the adaptor module;
- Fig. 4: illustrates one exemplary implementation of a signal processing unit applied in the adaptor module; and
- Fig. 5: illustrates one exemplary implementation of the signal processing unit with a two-state switch;

### DESCRIPTION

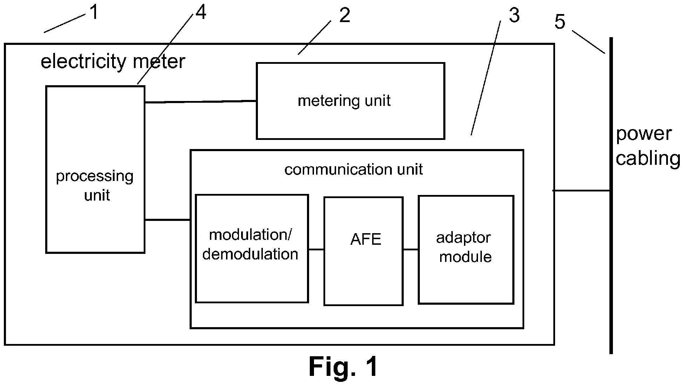

Fig. 1 shows a schematic diagram of an electricity meter 1, which comprises a metering unit 2, a communication unit 3 and a processing unit 4. The metering unit 2 measures for example current and voltage to determine the electric power and the energy consumption- or production. The communication unit 3 communicates data signals such as the determined electric energy consumption or production, diagnostic data of the electricity meter 1 and information data from and to the utilities, within a communication band over power cabling 5. The processing unit controls the metering unit 2 and the communication unit 3.

A plurality of frequency bands are allocated as communication bands for communication over power cabling 5. The electricity meter 1 is configured to switch from one of the allocated frequency bands to another allocated frequency band depending on the communication environment.

In one embodiment as shown in Fig. 1 the communication unit includes a modulation/demodulation module to modulate/demodulate the data signals on a carrier signal, an analog front end and an adaptor module. The switching of the frequency band is in particular achieved by operating the adaptor module in two operation modi.

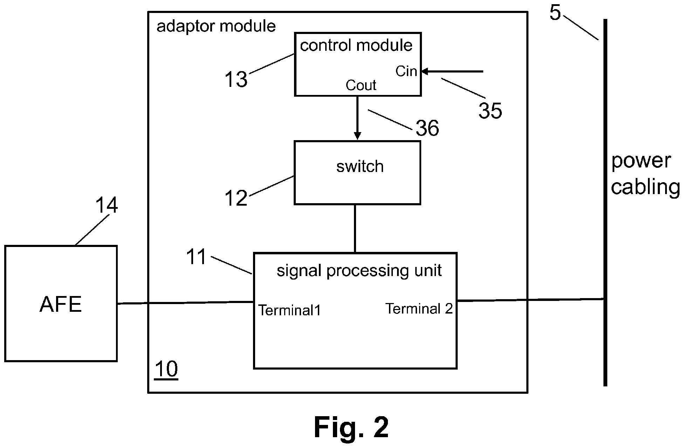

Fig. 2 shows a schematic diagram of an adaptor module 10 for an electricity meter according to the disclosure. The reference number 10 refers to the adaptor module 10, which comprises a signal processing unit 11, a switch 12 and a control module 13. Since the adaptor module 10 is designed to be applied for communication over power cabling 5, The terminal 2 of the signal processing unit 11 is connected to a power cabling 5 having a voltage of for example 230 volt or 110 volt depending on the country of operation. The terminal 1 of the signal processing unit 11 is connected to the analog front end 14. The signal processing unit 11 selects the electrical signals having a frequency within a defined frequency band and couples the selected electrical signals to the power cabling 5 and vice versa. As shown in Fig. 2, a switch 12 is connected to the signal processing unit 11 and a control module 13 is applied to control the switch 12. In order to provide a versatile adaptor module 10, the signal processing unit 11 has at least two operation modi, which depend on the state of the switch 12. The switch has at least two states. Depending on the number of operation modi of the signal processing unit 11, a suitable switch having at least the same number of states is to be used.

In one embodiment, the signal processing unit 11 has two operation modi, a switch 12 with two states is chosen. The control module 13 generates a control signal 36 to control the switch 12 changing from a first state to a second state. In a first operation modi, the signal processing unit 11 selects the electrical signals having a frequency within a first frequency band and couples the selected signal to the power cabling and vice versa. In a second modi, the signal processing unit 11 selects electrical signals having a frequency within a second frequency band and couples the selected signal to power cabling 5 and vice versa. The first frequency band may be for example CENELEC A frequency band and the second frequency band may be for example FCC frequency band and vice versa. To operate the signal processing unit 11 in the first mode, the switch 12 is controlled to a first state. To operate the signal processing unit 11 in the second mode, the switch 12 is controlled to a second state. The control module 13 is configured to generate a switch control signal 36 based on a configuration signal 35. As shown in Fig. 2, the control module 13 includes at least one input terminal Cin for receiving the configuration signal 35 and an output terminal Cout for providing the switch control signal 36 to control the switch 12. As will be described later in more detail, the configuration signal 35 can be generated locally or remotely. Furthermore, the configuration signal 35 can be generated dynamically.

In a variant, the configuration signal 35 is generated by a configuration tool, which is for example utilized by a service technician for installation or reconfiguration of a metering device, wherein the adaptor module 10 is installed. The configuration tool may be a software module, a hardware module, or a combination thereof. Furthermore, the configuration tool may be an external device or a part of the electricity meter which includes the adaptor module 10. In case the adaptor module 10 is installed in an electricity meter, the configuration tool may be arranged in the electricity meter or connected externally to the electricity meter. After receiving the configuration signal 35, the control module 13 generates the control signal 36 to control the switch 12 to one of the states. The control module 13 may be a software module, a hardware module, or a combination thereof.

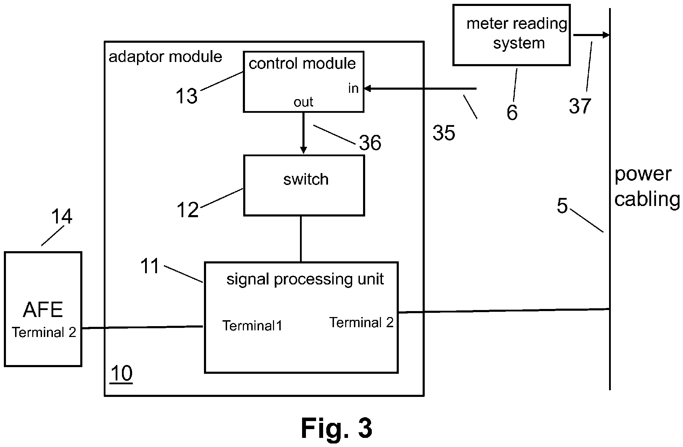

Fig. 3 illustrates a variant of remotely generating the configuration signal 35. In this case, the configuration signal 35 is initiated by an initiation signal 37 generated for example by a meter reading system 6. The initiation signal 37 is transmitted over power cabling 5 or a radio communication channel to the electricity meter, wherein the adaptor module 10 is installed. Based on the received initiation signal 37, the electricity meter set the configuration signal 35 for the control module 13. For example, the processing unit included in the electricity meter may provide this function.

In an alternative configuration, this embodiment may include a logic module (not shown in the figures) functionally connected to the control module 13 or processing unit 4 of the electricity meter 1 wherein the adaptor module is installed. The logic module may be self-learning and/or auto-detecting and may generate a configuration signal 35. In this way, the configuration signal 35 is dynamically generated.

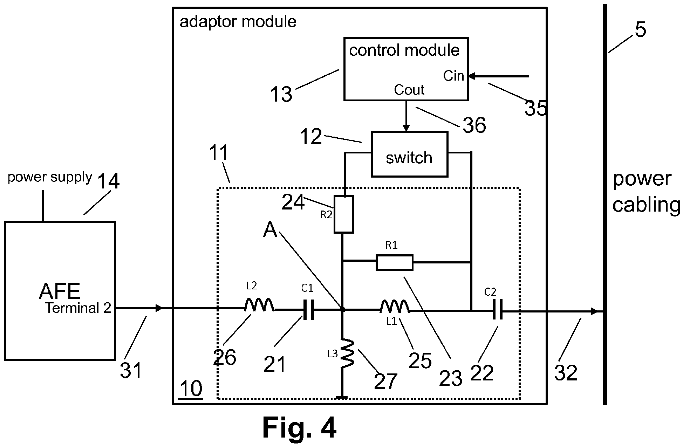

Fig. 4 illustrates one embodiment of the implementation of the adaptor module 10. It is to be mentioned that the embodiment presented herein describes merely one example of hardware implementing the signal processing unit 11. However, one skilled in the art will understand that different circuit implementations are possible, which provide the same functionality. As shown in Fig. 4, the signal processing unit 11 comprises a first resistor 23, a first capacitor 21, a second capacitor 22, and a first inductor 25. The first capacitor 21 and the second capacitor 22 are connected in series with the first inductor 25 being arranged between the first capacitor 21 and the second capacitor 22. The first resistor 23 is connected in parallel to the first inductor 25. These four elements form a band-pass filter, in particular a LC resonance circuit. The central frequency of the resonance circuit is mainly defined by the values of the first capacitor 21, the second capacitor 22 and the first inductor 25. The quality factor of the resonance circuit is partly defined by the value of the first resistor 23, which is connected in parallel to the first inductor 25. The band-pass filter removes the out-of band signals from the signal path before they are coupled to the power cabling 5.

In one embodiment, a second inductor 26 is arranged in the adaptor module 10 for a slight decoupling of the resonance circuit from an analog front end 14. Therefore, in case of adding this decoupling feature, the second inductor 26 is used and connected between the analog front end 14 and the band-pass filter, preferably, between the analog front end 14 and the first capacitor 21. The analog front end 14 includes filtering unit, receiver amplifier and transmitter amplifier. Preferably, the analog front end 14 is an integrated circuit to have a compact design and to reduce the loads caused by the long wire connections for example between the filter unit and the amplifiers. The analog front end 14 operates with a power supply voltage, which is much lower than the voltage of the power cabling 5, normally in the range of 10 volt or several 10 volts. Therefore, the signal processing unit 11 must be capable of adapting electrical signals having a voltage in the range of the supply voltage of the analog front end 14 to the voltage of the power cabling 5, such as from 10 volt to 220 volt.

In one embodiment, a third inductor 27 is arranged between node A and ground to attenuate the low frequency power line signals like mains frequency of 50 Hz or 60 Hz at the input of the analog front end 14. As shown in Fig. 4, the terminal 2 of the analog front end is connected to the signal processing unit 11. In the embodiment shown in Fig. 4, the switch 12 is connected with a protection resistor 24 in series. Switch 12 in series to and the protection resistor 24 are arranged in parallel to the first inductor 25. The protection resistor 24 is optionally connected in series with the switch 12. Fig.4 illustrates the signal flow for the case of transmitting electrical signals to the power cabling 5. The signal processing unit 11 receives a first electrical signal 31 from the analog front end 14 and outputs a second electrical signal 32 to the power cabling 5. It should be mentioned, that the circuit arrangement shown in Fig. 4 may also be applied for receiving electrical signals from power cabling 5. The signal flow is then in opposite direction.

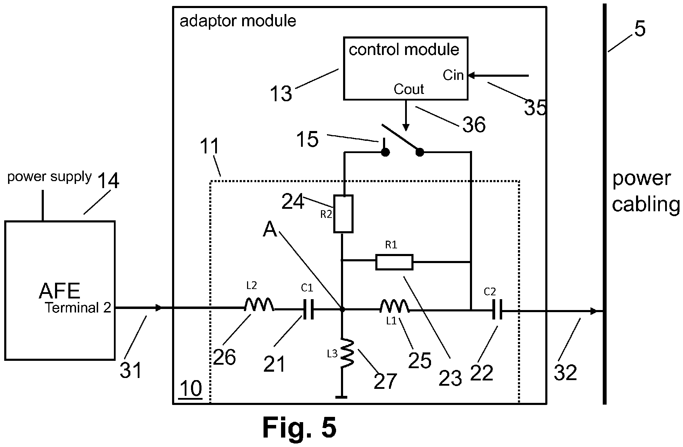

Fig. 5 illustrates an specific embodiment of the adaptor module 10, wherein a two-state switch 15 having an open state and a closed state is used and the signal processing unit 11 has a low-frequency band mode and a high-frequency band mode, for example "CENELEC-A" mode and a "FCC-band" mode, respectively. It should be mentioned, that the present disclosure is not limited to these specific frequency bands and to the values of the electric elements disclosed. As depicted in Fig. 5, at the open state of the two-state switch 15, the first electrical signal 31 passes through the band-pass filter formed by the first capacitor 21, the second capacitor 22, the first inductor 27 and the first resistor 23. For example, the values of these four elements are chosen such that the center frequency of the band-pass filter is set at 68 kHz for the application of CENELEC-A mode. At the closed-state of the two-state switch 15, the first inductor 25 and the first resistor 23 are shunt by the two-state switch 15, therefore, the first electrical signal 31 passes through a high-pass filter having a different filter characteristics for the application of FCC mode, for example, the cut-off frequency is set at the lower frequency of the FCC band, namely 155 kHz.

**List of References**

| | | |
|---|---|---|
| 1 | electricity meter | 37 initiation signal |
| 2 | metering unit | |
| 3 | communication unit | |
| 4 | processing unit | |
| 5 | power cabling | |
| 6 | meter reading system | |
| 10 | adaptor module | |
| 11 | signal processing unit | |
| 12 | switch | |
| 13 | control module | |
| 14 | analog front end | |
| 15 | two-state switch | |
| 21 | first capacitor (C1) | |
| 22 | second capacitor (C2) | |
| 23 | first resistor (R1) | |
| 24 | protection resistor (R2) | |
| 25 | first inductor (L1) | |
| 26 | second inductor (L2) | |
| 27 | third inductor (L3) | |
| 31 | first electrical signal | |
| 32 | second electrical signal | |
| 35 | configuration signal | |
| 36 | control signal | |

## Claims

1. An electricity meter (1) comprising:
a metering unit (2) for determining the electric energy consumption;
a communication unit (3) for communicating data signals within a communication band over power cabling; and
a processing unit for controlling the metering unit (2) and the communication unit (3);
wherein the communication unit (3) is configured to adapt the communication band to the communication environment;
**characterised in that**
the communication unit (3) comprises a signal processing unit, a switch (12) being connected to the signal processing unit (11), and a control module (13) for controlling the switch (12);
wherein the signal processing unit (11) has at least two operation modi depending on the state of the switch (12) controlled by the control module (13);
in a first operation mode, the signal processing unit (11) selects electrical signals from a first frequency band and couples the selected electrical signals to a power cabling;
in a second operation mode, the signal processing unit (11) selects electrical signals from a second frequency band and couples the selected electrical signals to the power cabling;
wherein the control module (13) is configured to generate a control signal (36) for controlling the switch (12) based on a configuration signal (35), and
wherein the configuration signal (35) is generated dynamically.

2. The electricity meter according to claim 1, wherein a plurality of frequency bands are allocated as communication bands for communication over power cabling, the communication unit (3) being configured to switch from one of the allocated frequency bands to another allocated frequency band depending on the communication environment.

3. The electricity meter according to claim 1 or 2, wherein
in the first operation mode, the signal processing unit (11) forms a band-pass filter to pass the electrical signals within the first frequency band; and
in the second operation mode, the signal processing unit forms a high-pass filter to pass the electrical signals within a second frequency band.

4. The electricity meter according to one of claims 1 to 3, wherein the first frequency band and the second frequency band are one of the allocated frequency bands for a communication over power cabling.

5. The electricity meter according to one of claims 1 to 4, wherein the configuration signal (35) is initiated by an initiation signal (37), which is transmitted over a power cabling (5) or a radio communication channel.

6. The electricity meter according to one of claims 1 to 5, wherein the switch (12) is a relay, preferably an optoisolated relay.

7. The electricity meter according to one of claims 1 to 6, wherein the signal processing unit (11) comprises a first resistor (23), a first capacitor (21), a second capacitor (22) and a first inductor (25), wherein the first capacitor (21), the second capacitor (22), and the first inductor (25) are connected in series with the first inductor (25) arranged between the first capacitor (21) and the second capacitor (22), wherein the first resistor (23) is connected in parallel to the first inductor (25).

8. An adaptor module (10) for an electricity meter (1) comprising:
a signal processing unit (11);
a switch (12) being connected to the signal processing unit (11);
and a control module (13) for control the switch (12);
wherein the signal processing unit (11) has at least two operation modi depending on the state of the switch (12) controlled by the controlling module (13);
in a first operation mode, the signal processing unit (11) selects electrical signals from a first frequency band and couples the selected electrical signals to a power cabling;
in a second operation mode, the signal processing unit (11) selects electrical signals from a second frequency band and couples the selected electrical signals to the power cabling;
wherein the control module (13) is configured to generate a control signal (36) for controlling the switch (12) based on a configuration signal (35); and
wherein the configuration signal (35) is generated dynamically.

9. The adaptor module according to claim 8, wherein a plurality of frequency bands are allocated as communication bands for communication over power cabling, the communication unit (3) being configured to switch from one of the allocated frequency bands to another allocated frequency band depending on the communication environment.

10. The adaptor module (10) according to claim 8 or 9, wherein
in the first operation mode, the signal processing unit (11) forms a band-pass filter to pass the electrical signals within the first frequency band; and
in the second operation mode, the signal processing unit forms a high-pass filter to pass the electrical signals within a second frequency band.

11. The adaptor module (10) according to one of claims 8 to 10, wherein the first frequency band and the second frequency band are one of the allocated frequency bands for a communication over power cabling.

12. The adaptor module according to one of claims 8 to 11, wherein the configuration signal (35) is initiated by an initiation signal (37), which is transmitted over a power cabling (5) or a radio communication channel.

13. The adaptor module according to one of claims 8 to 12, wherein the switch (12) is a relay, preferably an optoisolated relay.

14. The adaptor module according to one of claims 8 to 13, wherein the signal processing unit (11) comprises a first resistor (23), a first capacitor (21), a second capacitor (22) and a first inductor (25), wherein the first capacitor (21), the second capacitor (22), and the first inductor (25) are connected in series with the first inductor (25) arranged between the first capacitor (21) and the second capacitor (22), wherein the first resistor (23) is connected in parallel to the first inductor (25).

## Patentansprüche

1. Stromzähler (1), umfassend:
eine Zähleinheit (2) zum Bestimmen des Stromverbrauchs;
eine Kommunikationseinheit (3) zum Kommunizieren von Datensignalen innerhalb eines Kommunikationsbandes über eine Stromverkabelung; und
eine Verarbeitungseinheit zum Steuern der Zähleinheit (2) und der Kommunikationseinheit (3);
wobei die Kommunikationseinheit (3) dazu ausgelegt ist, das Kommunikationsband an die Kommunikationsumgebung anzupassen;
**dadurch gekennzeichnet, dass**
die Kommunikationseinheit (3) eine Signalverarbeitungseinheit, einen Schalter (12), der mit der Signalverarbeitungseinheit (11) verbunden ist, und ein Steuerungsmodul (13) zum Steuern des Schalters (12) umfasst;
wobei die Signalverarbeitungseinheit (11) mindestens zwei Betriebsmodi aufweist, die von dem Zustand des von dem Steuerungsmodul (13) gesteuerten Schalters (12) abhängen;
in einem ersten Betriebsmodus die Signalverarbeitungseinheit (11) elektrische Signale aus einem ersten Frequenzband auswählt und die ausgewählten elektrischen Signale mit einer Stromverkabelung koppelt;
in einem zweiten Betriebsmodus die Signalverarbeitungseinheit (11) elektrische Signale aus einem zweiten Frequenzband auswählt und die ausgewählten elektrischen Signale mit der Stromverkabelung koppelt;
wobei das Steuerungsmodul (13) dazu ausgelegt ist, ein Steuerungssignal (36) zum Steuern des Schalters (12) basierend auf einem Konfigurationssignal (35) zu erzeugen, und
wobei das Konfigurationssignal (35) dynamisch erzeugt wird.

2. Stromzähler nach Anspruch 1, wobei eine Vielzahl von Frequenzbändern als Kommunikationsbänder für die Kommunikation über die Stromverkabelung zugeordnet sind, wobei die Kommunikationseinheit (3) dazu ausgestaltet ist, abhängig von der Kommunikationsumgebung von einem der zugeordneten Frequenzbänder auf ein anderes zugeordnetes Frequenzband zu wechseln.

3. Stromzähler (1) nach Anspruch 1 oder 2, wobei
in dem ersten Betriebsmodus die Signalverarbeitungseinheit (11) einen Bandpassfilter bildet, um die elektrischen Signale innerhalb des ersten Frequenzbands weiterzuleiten; und
in dem zweiten Betriebsmodus die Signalverarbeitungseinheit einen Hochpassfilter bildet, um die elektrischen Signale innerhalb eines zweiten Frequenzbands weiterzuleiten.

4. Stromzähler nach einem der Ansprüche 1 bis 3, wobei das erste Frequenzband und das zweite Frequenzband eines der zugeordneten Frequenzbänder für eine Kommunikation über eine Stromverkabelung sind.

5. Stromzähler nach einem der Ansprüche 1 bis 4, wobei das Konfigurationssignal (35) von einem Auslösesignal (37) ausgelöst wird, das über eine Stromverkabelung (5) oder einen Funkkommunikationskanal übertragen wird.

6. Stromzähler nach einem der Ansprüche 1 bis 5, wobei der Schalter (12) ein Relais, vorzugsweise ein optoisoliertes Relais ist.

7. Stromzähler nach einem der Ansprüche 1 bis 6, wobei die Signalverarbeitungseinheit (11) einen ersten Widerstand (23), einen ersten Kondensator (21), einen zweiten Kondensator (22) und einen ersten Induktor (25) umfasst, wobei der erste Kondensator (21), der zweite Kondensator (22) und der erste Induktor (25) mit dem ersten Induktor (25) in Reihe geschaltet sind, der zwischen dem ersten Kondensator (21) und dem zweiten Kondensator (22) angeordnet ist, wobei der erste Widerstand (23) mit dem ersten Induktor (25) parallel geschaltet ist.

8. Anpassungsmodul (10) für einen Stromzähler (1), umfassend:
eine Signalverarbeitungseinheit (11);
einen Schalter (12), der mit der Signalverarbeitungseinheit (11) verbunden ist;
und ein Steuerungsmodul (13) zum Steuern des Schalters (12);
wobei die Signalverarbeitungseinheit (11) mindestens zwei Betriebsmodi aufweist, die von dem Zustand des von dem Steuerungsmodul (13) gesteuerten Schalters (12) abhängen;
in einem ersten Betriebsmodus die Signalverarbeitungseinheit (11) elektrische Signale aus einem ersten Frequenzband auswählt und die ausgewählten elektrischen Signale mit einer Stromverkabelung koppelt;
in einem zweiten Betriebsmodus die Signalverarbeitungseinheit (11) elektrische Signale aus einem zweiten Frequenzband auswählt und die ausgewählten elektrischen Signale mit der Stromverkabelung koppelt;
wobei das Steuerungsmodul (13) dazu ausgelegt ist, ein Steuerungssignal (36) zum Steuern des Schalters (12) basierend auf einem Konfigurationssignal (35) zu erzeugen; und
wobei das Konfigurationssignal (35) dynamisch erzeugt wird.

9. Anpassungsmodul nach Anspruch 8, wobei eine Vielzahl von Frequenzbändern als Kommunikationsbänder für die Kommunikation über eine Stromverkabelung zugeordnet sind, wobei die Kommunikationseinheit (3) dazu ausgestaltet ist, abhängig von der Kommunikationsumgebung von einem der zugeordneten Frequenzbänder auf ein anderes zugeordnetes Frequenzband zu wechseln.

10. Anpassungsmodul (10) nach Anspruch 8 oder 9, wobei
in dem ersten Betriebsmodus die Signalverarbeitungseinheit (11) einen Bandpassfilter bildet, um die elektrischen Signale innerhalb des ersten Frequenzbands weiterzuleiten; und
in dem zweiten Betriebsmodus die Signalverarbeitungseinheit einen Hochpassfilter bildet, um die elektrischen Signale innerhalb eines zweiten Frequenzbands weiterzuleiten.

11. Anpassungsmodul nach einem der Ansprüche 8 bis 10, wobei das erste Frequenzband und das zweite Frequenzband eines der zugeordneten Frequenzbänder für eine Kommunikation über eine Stromverkabelung sind.

12. Anpassungsmodul nach einem der Ansprüche 8 bis 11, wobei das Konfigurationssignal (35) von einem Auslösesignal (37) ausgelöst wird, das über eine Stromverkabelung (5) oder einen Funkkommunikationskanal übertragen wird.

13. Anpassungsmodul nach einem der Ansprüche 8 bis 12, wobei der Schalter (12) ein Relais, vorzugsweise ein optoisoliertes Relais ist.

14. Anpassungsmodul nach einem der Ansprüche 8 bis 13, wobei die Signalverarbeitungseinheit (11) einen ersten Widerstand (23), einen ersten Kondensator (21), einen zweiten Kondensator (22) und einen ersten Induktor (25) umfasst, wobei der erste Kondensator (21), der zweite Kondensator (22) und der erste Induktor (25) mit dem ersten Induktor (25) in Reihe geschaltet sind, der zwischen dem ersten Kondensator (21) und dem zweiten Kondensator (22) angeordnet ist, wobei der erste Widerstand (23) mit dem ersten Induktor (25) parallel geschaltet ist.

## Revendications

1. Compteur électrique (1) comprenant :
une unité de mesure (2) pour déterminer la consommation d'énergie électrique ;
une unité de communication (3) pour communiquer des signaux de données dans une bande de communication sur un câblage d'alimentation ; et
une unité de traitement pour commander l'unité de mesure (2) et l'unité de communication (3) ;
l'unité de communication (3) étant configurée pour adapter la bande de communication à l'environnement de communication ;
**caractérisé par le fait que**
l'unité de communication (3) comprend une unité de traitement de signal, un commutateur (12) connecté à l'unité de traitement de signal (11), et un module de commande (13) pour commander le commutateur (12) ;
l'unité de traitement de signal (11) ayant au moins deux modes de fonctionnement selon l'état du commutateur (12) commandé par le module de commande (13) ;
dans un premier mode de fonctionnement, l'unité de traitement de signal (11) sélectionnant des signaux électriques à partir d'une première bande de fréquences et couplant les signaux électriques sélectionnés à un câblage d'alimentation ;
dans un second mode de fonctionnement, l'unité de traitement de signal (11) sélectionnant des signaux électriques à partir d'une seconde bande de fréquences et couplant les signaux électriques sélectionnés au câblage d'alimentation ;
le module de commande (13) étant configuré pour générer un signal de commande (36) pour commander le commutateur (12) sur la base d'un signal de configuration (35), et
le signal de configuration (35) étant généré dynamiquement.

2. Compteur électrique selon la revendication 1, dans lequel une pluralité de bandes de fréquences sont allouées en tant que bandes de communication pour une communication sur câblage d'alimentation, l'unité de communication (3) étant configurée pour commuter de l'une des bandes de fréquences allouées à une autre bande de fréquences allouée en fonction de l'environnement de communication.

3. Compteur électrique selon la revendication 1 ou 2, dans lequel
dans le premier mode de fonctionnement, l'unité de traitement de signal (11) forme un filtre passe-bande pour laisser passer les signaux électriques dans la première bande de fréquences ; et
dans le second mode de fonctionnement, l'unité de traitement de signal forme un filtre passe-haut pour laisser passer les signaux électriques dans une seconde bande de fréquences.

4. Compteur électrique selon l'une des revendications 1 à 3, dans lequel la première bande de fréquences et la seconde bande de fréquences sont l'une des bandes de fréquences allouées pour une communication sur câblage d'alimentation.

5. Compteur électrique selon l'une des revendications 1 à 4, dans lequel le signal de configuration (35) est initié par un signal d'initiation (37), qui est émis sur un câblage d'alimentation (5) ou sur un canal de communication radio.

6. Compteur électrique selon l'une des revendications 1 à 5, dans lequel le commutateur (12) est un relais, de préférence un relais opto-isolé.

7. Compteur électrique selon l'une des revendications 1 à 6, dans lequel l'unité de traitement de signal (11) comprend une première résistance (23), un premier condensateur (21), un second condensateur (22) et une première bobine d'induction (25), le premier condensateur (21), le second condensateur (22) et la première bobine d'induction (25) étant montés en série avec la première bobine d'induction (25) disposée entre le premier condensateur (21) et le second condensateur (22), la première résistance (23) étant montée en parallèle de la première bobine d'induction (25).

8. Module adaptateur (10) pour un compteur électrique (1) comprenant :
une unité de traitement de signal (11) ;
un commutateur (12) connecté à l'unité de traitement de signal (11) ;
et un module de commande (13) pour commander le commutateur (12) ;
l'unité de traitement de signal (11) ayant au moins deux modes de fonctionnement selon l'état du commutateur (12) commandé par le module de commande (13) ;
dans un premier mode de fonctionnement, l'unité de traitement de signal (11) sélectionnant des signaux électriques à partir d'une première bande de fréquences et couplant les signaux électriques sélectionnés à un câblage d'alimentation ;
dans un second mode de fonctionnement, l'unité de traitement de signal (11) sélectionnant des signaux électriques à partir d'une seconde bande de fréquences et couplant les signaux électriques sélectionnés au câblage d'alimentation ;
le module de commande (13) étant configuré pour générer un signal de commande (36) pour commander le commutateur (12) sur la base d'un signal de configuration (35) ; et
le signal de configuration (35) étant généré dynamiquement.

9. Module adaptateur selon la revendication 8, dans lequel une pluralité de bandes de fréquences sont allouées en tant que bandes de communication pour une communication sur câblage d'alimentation, l'unité de communication (3) étant configurée pour commuter de l'une des bandes de fréquences allouées à une autre bande de fréquences allouée en fonction de l'environnement de communication.

10. Module adaptateur (10) selon la revendication 8 ou 9, dans lequel
dans le premier mode de fonctionnement, l'unité de traitement de signal (11) forme un filtre passe-bande pour laisser passer les signaux électriques dans la première bande de fréquences ; et
dans le second mode de fonctionnement, l'unité de traitement de signal forme un filtre passe-haut pour laisser passer les signaux électriques dans une seconde bande de fréquences.

11. Module adaptateur (10) selon l'une des revendications 8 à 10, dans lequel la première bande de fréquences et la seconde bande de fréquences sont l'une des bandes de fréquences allouées pour une communication sur câblage d'alimentation.

12. Module adaptateur selon l'une des revendications 8 à 11, dans lequel le signal de configuration (35) est initié par un signal d'initiation (37), qui est émis sur un câblage d'alimentation (5) ou sur un canal de communication radio.

13. Module adaptateur selon l'une des revendications 8 à 12, dans lequel le commutateur (12) est un relais, de préférence un relais opto-isolé.

14. Module adaptateur selon l'une des revendications 8 à 13, dans lequel l'unité de traitement de signal (11) comprend une première résistance (23), un premier condensateur (21), un second condensateur (22) et une première bobine d'induction (25), le premier condensateur (21), le second condensateur (22) et la première bobine d'induction (25) étant montés en série avec la première bobine d'induction (25) disposée entre le premier condensateur (21) et le second condensateur (22), la première résistance (23) étant montée en parallèle de la première bobine d'induction (25).
